Europäisches Patentamt

(19) European Patent Office

Office européen des brevets

(11) Numéro de publication: **0 034 995**
**B1**

(12) **FASCICULE DE BREVET EUROPEEN**

(45) Date de publication du fascicule du brevet:
**10.10.84**

(51) Int. Cl.³: **C 30 B 21/02,** C 30 B 11/00,
B 22 D 27/04, C 30 B 3/00

(21) Numéro de dépôt: **81420024.2**

(22) Date de dépôt: **25.02.81**

(54) **Dispositif et son utilisation pour l'élaboration et le traitement des composites eutectiques et eutectoides.**

(30) Priorité: **26.02.80 FR 8004496**

(43) Date de publication de la demande:
**02.09.81 Bulletin 81/35**

(45) Mention de la délivrance du brevet:
**10.10.84 Bulletin 84/41**

(84) Etats contractants désignés:
**AT BE CH DE GB IT LI LU NL SE**

(56) Documents cités:
**DE - A - 1 806 843**
**DE - A - 1 945 094**
**FR - A - 2 130 081**
**FR - A - 2 282 667**

(73) Titulaire: **Bo, Ermanno, Chemin de Monte-Ferrand,
Ternay F-69360 St-Symphorien d'Ozon (FR)**
Titulaire: **Mathia, Tadeusz G., Allée des Chênes,
F-69260 Charbonnières-les-Bains (FR)**

(72) Inventeur: **Mathia, Tadeusz G., Allée des Chênes,
F-69260 Charbonnières-les-Bains (FR)**

(74) Mandataire: **Schmitt, John, 9 Rue Pizay, F-69001 - Lyon
(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

BUNDESDRUCKEREI BERLIN

## Description

La présente invention concerne un dispositif d'élaboration et de traitement des divers matériaux composites anisotropes, métalliques et céramiques, permettant de transformer aussi bien des alliages eutectiques à l'état de fusion que des eutectoïdes à l'état solide.

On sait que parmi les divers matériaux composites anisotropes, les alliages eutectoïdes orientés, ainsi que la solidification orientée des alliages eutectiques, ont fait l'objet de nombreuses études techniques expérimentales qui ont démontré que la direction de croissance qui conduit à une structure fibreuse ou lamellaire des alliages est imposée par la translation du four et le gradient de température. Dans les deux cas, après élaboration sous vide dans un four à induction, les alliages sont orientés dans un four à résistance mobile verticalement ce qui permet d'obtenir une orientation unidirectionnelle.

Le dispositif selon l'invention permet de réaliser à la fois la fusion en zone flottante des eutectiques et l'orientation des eutectoïdes, ainsi que la fusion, le frittage et/ou une homogénéisation avant orientation avec les moyens indiqués dans la revendication 1.

Selon l'invention, on procède à la solidification des eutectiques en présence d'un fort gradient thermique tout en imposant dans la direction de ce gradient une vitesse de déplacement au front de silidification, ceci étant réalisé par la translation et/ou les rotations et/ou les déplacements des gradients de température. Le solide obtenu présente une structure fibreuse ou lamellaire orientée suivant la direction des croissances imposées.

Dans le cas des eutectoïdes l'orientation des fibres s'effectue suivant la direction de croissance et/ou des précipitations imposées par la translation et/ou les rotations et/ou les déplacements des gradients de température.

Avec le dispositif selon l'invention les vitesses élevées de translation et/ou de rotation sont utilisées durant l'opération de frittage afin d'améliorer la compacité et de ce fait, de réduire la porosité résiduelle du composite obtenu, tandis que les vitesses lentes de translation et/ou de rotation sont utilisées pendant l'opération d'homogénéisation et durant la phase d'orientation des fibres ou des lamelles.

On décrit ci-après à l'aide de dessins un exemple d'installation permettant de mettre en oeuvre de procédé d'élaboration des composites eutectiques et eutectoïdes.

La figure 1 représente schématiquement une installation, suivant l'invention, convenant à la fois au traitement des eutectiques et des eutectoïdes;

La figure 2 représente schématiquement l'installation précédente pendant la phase d'orientation. Cette figure est accompagnée du diagramme du processus de l'orientation axiale des fibres;

La figure 3 représente schématiquement l'installation en phase d'orientation radiale de la structure fibreuse ou lamellaire de l'alliage. Cette figure est accompagnée du diagramme du processus de l'orientation radiale des fibres.

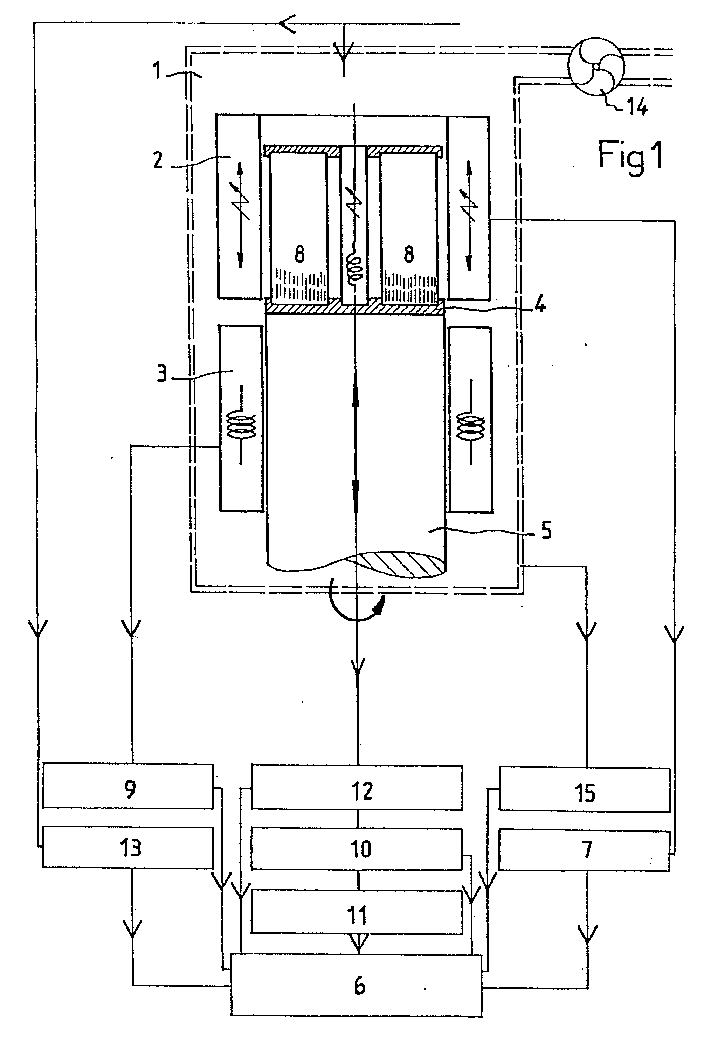

Suivant la figure 1 on voit que l'installation comporte, dans une enceinte réfractaire étanche 1, un double système de chauffage 2, un double système de refroidissement 3, un plateau-support 4 des pièces à traiter fixé à l'extrémité d'un arbre de mise en mouvement 5; chacun des systèmes 2—3 et le plateau-support 4 étant susceptible d'être animé de mouvements dans les trois dimensions, l'ensemble étant asservi par un programmateur électronique central 6.

Le double système de chauffage 2 comprend un chauffage par induction utilisant le courant haute fréquence alimenté par un générateur à fréquence variable, non représenté, et qui est employé dans le cas de matériaux peu conducteurs. L'autre système est un chauffage par résistance employé dans le cas de matériaux fortement conducteurs car il évite des interfaces solides liquides et incurvées. Ces deux systèmes de chauffage sont également utilisés de manière alternée en vue d'une réalisation des différentes phases: frittage, homogénéisation, fusion etc...

Chaque élément chauffant possède sa propre régulation 7 commandée par des sondes de températures situées au voisinage des pièces traitées 8 et informant le programmateur central 6.

Le double système de refroidissement 3 est constitué par un serpentin ou une rampe ou autres dispositifs, permettant le transport et la circulation du fluide de refroidissement. Ce double système comprend un circuit primaire cryogénique et un circuit secondaire à circulation forcée du fluide de refroidissement qui sont régulés en 9 autant pour leur débit que pour les mouvements de translation et/ou de rotation qu'ils ont à effectuer dans leur espace et ce, dans les trois dimensions, l'ensemble de cette régulation étant également asservi par le même programmateur central 6.

L'enceinte 1 est conçue et réalisée de façon à permettre les translations et/ou rotations des systèmes de chauffage 2, de refroidissement 3 et du dispositif plateau-support 4 des pièces à traiter. Ce plateau-support 4 comporte un dispositif assurant son déplacement dans les trois dimensions en utilisant des vitesses de translation et/ou de rotation adéquates par l'intermédiaire de moteurs à courant continu ou autres, non représentés, régulés en 10—11 à partir de capteurs de déplacement et commandés par le programmateur central 6. Ce système de déplacement du plateau-support 5 peut être indépendant du système d'orientation des ensembles de chauffage et de refroidissement.

Un détecteur de couple de frottement visqueux 12 pris en considération par le programmateur central 6 contrôle »in situ« la progression de la zone orientée de la pièce 8 fixée sur le plateau-support 4.

L'enceinte 1 possède un système anti-oxydation et anti-corrosion; elle est mise sous atmosphère d'argon purifié ou de gaz inerte évitant toute oxydation parasite sur les matériaux traités. Ce système d'alimentation en gaz 13 permet également d'utiliser l'enceinte 1 pour effectuer des traitements thermiques en phase gazeuse.

Un dispositif de pompage 14 permet la mise sous vide à $10^{-2}$ ou $10^{-4}$ pascals ou moins, de l'enceinte pendant la fusion des eutectiques et/ou le frittage des poudres pour les eutectoïdes et/ou suivant le cas pendant l'élaboration du composite. La régulation de la mise sous vide se fait en 15 figure 1.

Le programmateur central 5 commande l'ensemble des phases d'élaboration des matériaux composites décrits plus haut.

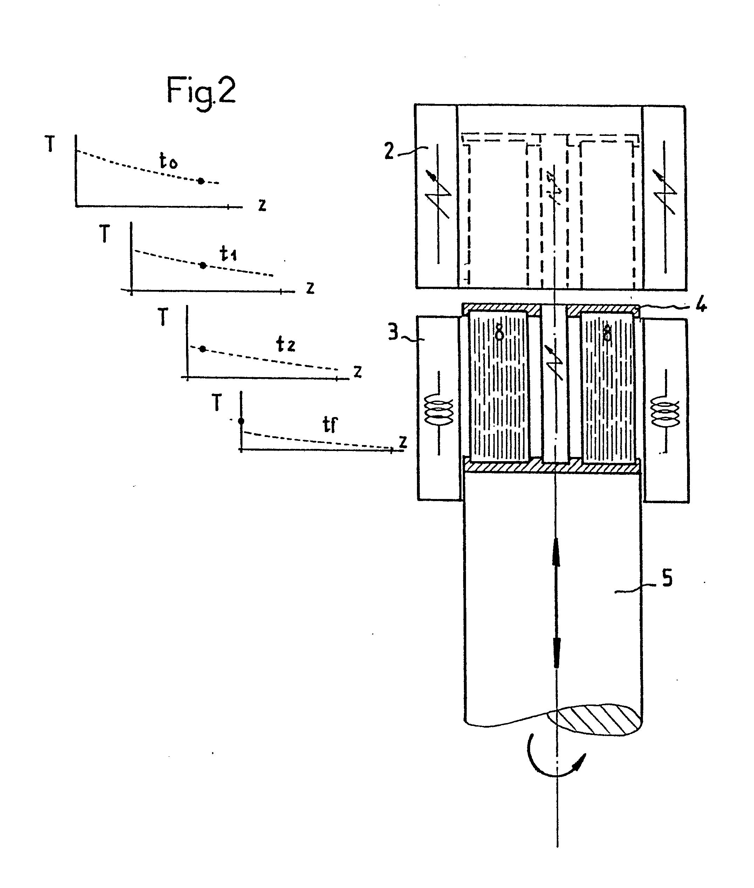

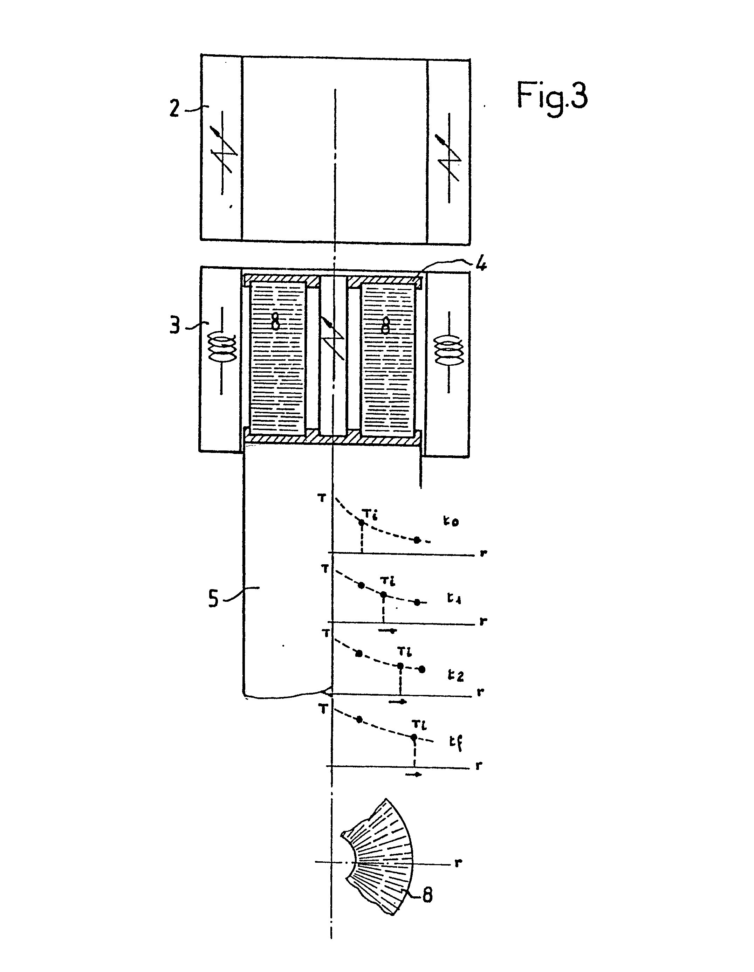

Les diagrammes qui accompagnent les figures 2 et 3 représentent le processus de formation et d'orientation de la fibre à l'intérieur de la pièce 8 à différents instants et/ou des positions to, t1, t2, tf dans un système de coordonnées Tz figure 2 et Tr figure 3.

Le traitement s'applique à toutes pièces sans restriction de formes: cylindrique, conique, parallélépipédique, sphérique, semi-sphérique etc... qu'elles soient pleines ou creuses, mais non exclusivement.

Le procédé présente, outre l'avantage d'orienter les lamelles et/ou les fibres d'une manière axiale, radiale ou courbe, celui de modifier l'orientation desdites fibres durant la phase d'élaboration. Il offre la possibilité d'élaboration d'alliages (frittages et fusion), d'homogénéisation et de traitement sur la même installation ainsi que le traitement de pièces de grandes dimensions et, dans certains cas, le traitement en coulée continue.

On peut envisager de nombreuses applications du procédé qui vient d'être décrit:

— applications tribologiques, c'est-à-dire tout ce qui concerne les pièces de frottement, telles que paliers, rotules, outils d'usinage;

— applications rhéologiques, c'est-à-dire tout ce qui a trait à la plasticité des éléments, leur viscosité, leur élasticité;

— applications décoratives, aspect particulier, fibreux, lamellaire;

— applications électriques, c'est-à-dire tout ce qui contribue au transport du courant électrique;

— applications magnétiques, c'est-à-dire tout ce qui traite de la conduction du champ magnétique.

— applications optiques et accoustiques, c'est-à-dire tout ce qui concerne ces transports.

— applications dans les industries chimiques et nucléaires en particulier pour la fabrication de vannes;

— applications aérospatiales et automobiles pour la fabrication d'ailettes de turbines, de réacteurs, collecteurs électriques, guides d'ondes.

Ces applications ne sont pas exclusives.

## Revendications

1. Dispositif d'élaboration de matériaux composites anisotropes, métalliques et céramiques permettant de réaliser la fusion en zone flottante des eutectiques, l'orientation des eutectoïdes, ainsi que la fusion, le frittage et/ou l'homogénéisation des matériaux avant orientation, ledit dispositif comprenant dans une enceinte réfractaire étanche (1), un double système de chauffage (2) précédant un double système de refroidissement (3) et un plateau-support (4) des pièces (8) en matériau à traiter pouvant se déplacer dans les deux systèmes précédents, caractérisé en ce que ledit dispositif comprend en outre des moyens de déplacement en translation et/ou rotation des systèmes de chauffage et de refroidissement (2, 3) ainsi que du plateau-support (4), et un programmateur électonique central (6) régulant par asservissement la température desdits systèmes de chauffage et de refroidissement (2, 3) et les déplacements de ces derniers et du plateau-support (4).

2. Dispositif suivant la revendication 1, caractérisé par le fait que le double système de chauffage (2) comprend un chauffage par induction utilisant le courant à haute fréquence fourni par un générateur à fréquence variable et un chauffage par résistance.

3. Dispositif suivant la revendication 1, caractérisé par le fait que le double système de refroidissement (3) comprend un système primaire cryogénique et un système secondaire à circulation forcée du fluide de refroidissement.

4. Dispositif suivant la revendication 1, caractérisé par le fait que le moyen de déplacement en translation et/ou rotation du plateau-support (4) comprend un arbre de mise en mouvement (5) dont une extrémité est fixée au plateau-support, et que ce moyen de déplacement est indépendant du système d'orientation des ensembles de chauffage (2) et de refroidissement (3).

5. Dispositif suivant la revendication 1, caractérisé par le fait que chaque double système de chauffage (2) ou de refroidissement (3) possède sa propre régulation par sondes de température situées au voisinage des pièces à traiter (8).

6. Dispositif suivant la revendication 1, caractérisé par le fait qu'il comprend des capteurs de déplacement assurant la régulation des mouvements de translation et/ou de rotation des systèmes de chauffage (2) et de refroidissement (3) et du plateau-support (4) ainsi que la régulation de leur vitesse.

7. Dispositif suivant la revendication 1, caractérisé par le fait qu'il comprend un détecteur de couple de frottement visqueux (12), contrôlant in-situ la progression de la zone orientée.

8. Dispositif suivant la revendication 1, caractérisé par le fait qu'il comprend une pompe (14) permettant la mise sous vide de l'enceinte (1).

9. Dispositif suivant la revendication 1, caractérisé par le fait qu'il comprend un système d'alimentation (13) permettant de créer une atmosphère de gaz inerte et/ou de gaz réactif à l'intérieur de l'enceinte (1).

10. Utilisation du dispositif selon l'une des revendications 1 à 9 à l'élaboration de matériaux composites par fusion en zone flottante et solidification des eutectiques par translation et/ou rotation et/ou déplacement des gradients de température pour que le solide obtenu présente une structure fibreuse ou lamellaire orientée suivant la direction des croissances imposées.

11. Utilisation du dispositif selon l'une des revendications 1 à 9 à l'obtention des matériaux composites avec orientation des eutectoïdes en imposant la direction des croissances et/ou des précipitations par translation et/ou rotation et/ou déplacement des gradients de température.

12. Utilisation selon l'une des revendications 10 ou 11, caractérisé en ce qu'on met l'enceinte en atmosphère réactive pendant et/ou après l'élaboration du composite pour le traitement de surface ou en volume de composite.

13. Utilisation du dispositif selon l'une des revendications 1 à 9 à l'élaboration de matériaux composites par frittage.


## Patentansprüche

1. Vorrichtung für die Erzeugung anisotroper zusammengesetzter Werkstoffe aus Metall und Keramik, welche die Schmelzung von Eutektika in schwebender Zone, die Ausrichtung von Eutektoiden, sowie die Schmelzung, Sinterung und/oder Homogenisierung der Werkstoffe vor der Ausrichtung gestattet, bestehend aus einem doppelten Heizsystem (2), das einem doppelten Kühlsystem (3) und einer Platte (4) für die Aufnahme der Teile (8) aus dem zu bearbeitenden Werkstoff vorgeschaltet ist, in einer feuerfesten abgedichteten Kammer (1), wobei sich die Platte in den beiden erwähnten Systemen bewegen kann, dadurch gekennzeichnet, daß die genannte Vorrichtung und die Aufnahmeplatte (4) außerdem Mittel für die Fahr- und/oder Drehbewegung der Heiz- und Kühlsysteme (2, 3), sowie ein zentrales elektronisches Programmiersystem besitzen, das die Temperatur der genannten Heiz- und Kühlsysteme (2, 3) und ihre Bewegungen sowie die der Aufnahmeplatte (4) automatisch regelt.

2. Vorrichtung gemäß Anspruch 1, gekennzeichnet dadurch, daß das doppelte Heizsystem (2) eine Induktionsheizung enthält, welche Hochfrequenzstrom verwendet, der von einem Generator mit verstellbarer Frequenz abgegeben wird, und eine Widerstandsheizung.

3. Vorrichtung gemäß Anspruch 1, dadurch gekennzeichnet, daß das doppelte Kühlsystem (3) für die Kälteerzeugung ein Primärsystem und ein Sekundärsystem mit Zwangsumlauf des Kühlmediums enthält.

4. Vorrichtung gemäß Anspruch 1, dadurch gekennzeichnet, daß das Mittel für die Fahr- und/oder Drehbewegung der Aufnahmeplatte (4) eine Antriebswelle (5) enthält, deren eines Ende an der Aufnahmeplatte befestigt ist, und daß dieses Bewegungsmittel unabhängig vom System für die Ausrichtung der Heiz- (2) und Kühl- (3)-Einheiten ist.

5. Vorrichtung gemäß Anspruch 1, dadurch gekennzeichnet, daß jedes doppelte Heiz- (2) oder Kühl- (3) -System seine eigene Regulierung durch Temperaturfühler besitzt, welche sich in unmittelbarer Nähe der zu behandelnden Teile (8) befinden.

6. Vorrichtung gemäß Anspruch 1, dadurch gekennzeichnet, daß sie Bewegungsmeßwertgeber enthält, welche die Regulierung der Fahr- und Drehbewegungen des Heiz- (2) und Kühl- (3) -Systems und der Aufnahmeplatte (4) sowie die Regulierung ihrer Geschwindigkeit gewährleisten.

7. Vorrichtung gemäß Anspruch 1, dadurch gekennzeichnet, daß sie einen Detektor (12) des zähflüssigen Reibungsmomentes enthält, welcher in-situ den Aufbau der ausgerichteten Zone überwacht.

8. Vorrichtung gemäß Anspruch 1, dadurch gekennzeichnet, daß sie eine Pumpe (14) enthält, welche den Aufbau eines Vakuums in der Kammer (1) ermöglicht.

9. Vorrichtung gemäß Anspruch 1, dadurch gekennzeichnet, daß sie ein Versorgungssystem (13) enthält, mit dem sich eine Atmosphäre aus Inert- und/oder Reaktionsgas im Innern der Kammer (1) erzeugen läßt.

10. Verwendung der Vorrichtung gemäß eines der Ansprüche 1 bis 9 für die Erzeugung zusammengesetzter Stoffe durch Schmelzung in schwebender Zone und Verfestigung der Eutektika durch Fahr- und/oder Drehbewegung und/ oder Verschiebung der Temperaturgradienten, um dem erhaltenen festen Stoff eine Faser- oder Lamellenstruktur zu verleihen, die nach der Richtung des aufgezwungenen Aufbaus ausgerichtet ist.

11. Verwendung der Vorrichtung gemäß eines der Ansprüche 1 bis 9 für die Erzeugung zusammengesetzter Werkstoffe mit Ausrichtung der Eutektoide durch Aufzwingung der Wachstumsrichtung und/oder der Fällungsrichtung durch Fahr- und/oder Drehbewegung und/oder Verschiebung der Temperaturgradienten.

12. Verwendung gemäß eines der Ansprüche 10 oder 11, dadurch gekennzeichnet, daß die Kammer während und/oder nach der Erzeugung des zusammengesetzten Werkstoffs für die Oberflächen- oder Volumenbearbeitung des Werkstoffs unter Reaktionsatmosphäre gesetzt wird.

13. Verwendung der Vorrichtung gemäß eines der Ansprüche 1 bis 9 für die Herstellung zusammengesetzter Werkstoffe durch Sinterung.

**Claims**

1. A device for forming composite anisotropic metal and ceramic materials for providing melting in the floating zone of the eutectics, orientation of the eutectoides, as well as the melting, sintering and/or homogenisation of the materials before orientation, said device comprising a sealed refractory enclosure (1), a double heating system (2) preceding a double cooling system (3) and a plate (4) for supporting the pieces (8) made from a material to be treated adapted to move in the two preceding systems, characterized in that said device further comprises means for translationally moving and/or rotating the heating and cooling systems (2, 3) as well as the support plate (4), and a central electronic programmer (6) regulating by servo-control the temperature of said heating and cooling systems (2, 3) and the movements of these latter and of the support plate (4).

2. The device according to claim 1, characterized by the fact that the double heating system (2) comprises induction heating using the high frequency current supplied by a variable frequency generator and resistance heating.

3. The device according to claim 1, characterized by the fact that the double cooling system (3) comprises a primary cryogenic system and a secondary system for forced circulation of the cooling fluid.

4. The device according to claim 1, characterized by the fact that the means for translationally moving and/or rotating the support plate (4) comprises a moving shaft (5) one end of which is fixed to the support plates and that this moving means is independent of the system for orientating the heating (2) and cooling (3) assemblies.

5. The device according to claim 1, characterized by the fact that each double heating (2) or cooling (3) system has its own regulation by means of temperature probes situated in the vicinity of the pieces to be treated (8).

6. The device according to claim 1, characterized by the fact that it comprises movement sensore providing regulation of the translational and/or rotational movements of the heating (2) and cooling (3) systems and of the support plate (4) as well as regulation of their speed.

7. The device according to claim 1, characterized by the fact that it comprises a viscous friction torque detector (12) controlling in-situ the progression of the orientated zone.

8. The device according to claim 1, characterized by the fact that it comprises a pump (14) for evacuating the enclosure (1).

9. The device according to claim 1, characterized by the fact that it comprises a supply system (13) for creating an inert gas and/or reactive gas atmosphere inside the enclosure (1).

10. The use of the device according to one of claims 1 to 9 for forming composite materials by melting in the floating zone and solidification of the eutectics by translation and/or rotation and/or movement of the temperature gradients so that the solid obtained has a fibrous or lamellar structure orientated in the direction of the imposed increases.

11. Use of the device according to one of claims 1 to 9 for obtaining composite materials with orientation of the eutectoids by imposing the direction of the increases and/or of the precipitations by translation and/or rotation and/or movement of the temperature gradients.

12. The use according to one of claims 10 or 11, characterized in that the enclosure is provided with a reactive atmosphere during and/or after formation of the composite material for surface or volume treatment of the composite material.

13. The use of the device according to one of claims 1 to 9, for forming composite materials by sintering.

Fig 1

Fig.2

Fig.3